# EUROPÄISCHE PATENTSCHRIFT

(11) **EP 0 645 808 B1**
(45) Veröffentlichungstag und Bekanntmachung des Hinweises auf die Patenterteilung: **15.03.2000**
(21) Anmeldenummer: 94112937.1
(22) Anmeldetag: 18.08.1994
(51) Int. Cl.: H01L 21/76, H01L 21/225

(54) **Verfahren zur Herstellung eines Isolationsgrabens in einem SOI-Substrat**
Process for manufacturing an isolation trench in a SOI substrate
Procédé de fabrication d'une rainure d'isolation dans un substrat du type SOI

(30) Priorität: 27.09.1993 DE 4332842
(43) Veröffentlichungstag der Anmeldung: 29.03.1995
(73) Patentinhaber: SIEMENS AKTIENGESELLSCHAFT, 80333 München (DE)
(72) Erfinder: Schwalke, Udo, Dr., D-84431 Heldenstein (DE)

(56) Entgegenhaltungen:
- EP-A- 0 296 754
- EP-A- 0 423 722
- EP-A- 0 515 809
- WO-A-85/04760
- US-A- 4 666 556
- IBM TECHNICAL DISCLOSURE BULLETIN., Bd.27, Nr.10A, März 1985, NEW YORK US Seiten 5501 - 5504 'SIDEWALL CHANNEL-STOP DOPING FOR DEEP-TRENCH ISOLATION OF FET DEVICES'
- JOURNAL OF THE ELECTROCHEMICAL SOCIETY, Bd.139, Nr.6, Juni 1992, MANCHESTER, NEW HAMPSHIRE US Seiten 1690 - 1692 K. FUJINO ET AL. 'SURFACE MODIFICATION OF BASE MATERIALS FOR TEOS/O3 ATMOSPHERIC PRESSURE CHEMICAL VAPOR DEPOSITION'
- PATENT ABSTRACTS OF JAPAN, Band 11, Nr. 195 (E-518) , 23-06-1987 & JP 62-022453

## Beschreibung

Bei der Integration von Bauelementen in SOI-Substraten, die eine monokristalline Siliziumschicht, eine darauf angeordnete isolierende Schicht aus SiO₂ und eine darauf angeordnete monokristalline Siliziumschicht umfassen, werden die Bauelemente in der monokristallinen Siliziumschicht realisiert. Benachbarte Bauelemente oder Bauelementgruppen werden vertikal durch die isolierende Schicht und lateral durch Gräben, die das jeweilige Bauelement oder die Bauelementgruppe vollständig umgeben, die in der Regel bis auf die isolierende Schicht reichen und die mit SiO₂ gefüllt sind, elektrisch vollständig gegeneinander isoliert. Für diese Isolation hat sich der Begriff dielektrische Isolation eingebürgert.

In der Smart-Power-Technologie werden komplexe Logikbauelemente mit Hochspannungsleistungsbauelementen monolithisch in einem Substrat integriert. Da die Logikbauelemente mit Spannungspegeln um 5 Volt betrieben werden, bei den Hochspannungs-Leistungsbauelementen jedoch Spannungen bis zu 500 Volt auftreten, ist eine elektrische Trennung der Hochspannungsbauelemente von den Logikbauelementen erforderlich. In der Smart-Power-Technologie (siehe zum Beispiel A. Nakagawa et al. ISPS 1990, Seite 97 - 101) wird zur elektrischen Trennung von Bauelementen die dielektrische Isolation bei Verwendung von SOI-Substraten angewendet.

Die Schichtdicke der monokristallinen Siliziumschicht eines SOI-Substrats beträgt in nach dem direkt wafer bonding (DWB)-Verfahren hergestellten SOI-Substraten (siehe zum Beispiel A. Nakagawa et al. ISPS 1990, Seite 97 - 101) typisch 20 µm. Das heißt, zur Herstellung von Isolationsgräben, die zu isolierende Bauelemente umgeben, müssen entsprechend tiefe, zum Beispiel 20 µm, Gräben in die monokristalline Siliziumschicht durch Trockenätzung geätzt werden.

Um sicherzustellen, daß die monokristalline Siliziumschicht überall auf dem SOI-Substrat vollständig durchätzt wird, wird die Ätzdauer in diesem Prozeßschritt in der Regel um 10 bis 50 % gegenüber dem Wert verlängert, bei dem die monokristalline Siliziumschicht gerade durchgeätzt wird. Zur Grabenätzung werden Trockenätzprozesse verwendet, die selektiv zu SiO₂ Silizium angreifen. Die Grabenätzung stoppt daher auf der Oberfläche der isolierenden Schicht des SOI-SubstratSeite Die verwendeten Trockenätzprozesse ätzen zwar anisotrop. Neben der hauptsachlichen vertikalen Ätzkomponente haben diese Ätzverfahren jedoch auch einen lateralen Anteil. Dieser führt bei der Überätzung dazu, daß sich an der Oberfläche der isolierenden Schicht Unterätzungen der monokristallinen Siliziumschicht bilden. Diese Unterätzungen der monokristallinen Siliziumschicht führen zu einer Aufweitung des Querschnitts des Grabens an der Oberfläche der isolierenden Schicht.

Diese Unterätzungen führen im weiteren Prozeßverlauf, insbesondere bei einer thermischen Oxidation der Seitenwände des Grabens, zu Schwierigkeiten. Bei der thermischen Oxidation der Seitenwände des Grabens bildet sich am Boden des Grabens im Bereich der Unterätzungen ein Vogelschnabel auSeite Da üblicherweise zur Grabenätzung eine eine Si₃N₄-Schicht enthaltende Grabenmaske verwendet wird, die bei der thermischen Oxidation der Seitenwände die Oberfläche der monokristallinen Siliziumschicht schützt, kommt es bei der thermischen Oxidation auch an der Oberkante des Grabens zur Ausbildung eines VogelschnabelSeite Die Bildung des Vogelschnabels ist eine Folge der Volumenvergrößerung bei der Oxidation. Dieser Vogelschnabel führt zu mechanischen Spannungen an der Grabenoberkante sowie am Grabenboden. An der Grabenoberkante können diese Spannungen durch Deformation der relativ dünnen Maskenschicht abgebaut werden. Am Grabenboden ist dieses jedoch nicht möglich.

Als Folge mechanischer Spannungen kommt es in der monokristallinen Siliziumschicht an der Grabenoberkante und am Grabenboden zur Ausbildung von Kristalldefekten. Je höher die mechanischen Spannungen sind, desto größer ist die Störung des KristallgitterSeite Diese Kristalldefekte beeinträchtigen die Funktion der in der monokristallinen Siliziumschicht integrierten Bauelemente. Sie reduzieren die Ausbeute.

Aus EP 0459397 A2 ist bekannt, bei der thermischen Oxidation der Oberfläche eines Grabens, der in ein Substrat aus monokristallinem Silizium geätzt ist, mechanische Spannungen durch die Ausbildung eines Vogelschnabels an der Grabenoberkante durch eine Abschrägung der Oberkante des Grabens durch Anätzen zu vermeiden.

Aus Y. Tamaki et al, J. Electrochem. Soc. 135, p. 726 (1988) ist bekannt, bei der thermischen Oxidation der Oberfläche eines Grabens, der in ein Substrat aus monokristallinem Silizium geätzt ist, durch Anätzen die Grabenoberkante abzuschrägen und den Grabenboden zu verrunden, um so mechanische Spannungen durch das entstehende SiO₂ zu vermeiden.

Aus US-PS 5061653 ist bekannt, seitlich eines Grabens, der in ein Substrat aus monokristallinem Silizium geätzt ist und dessen Oberfläche oxidiert ist, einen Feldoxidvogelschnabel auszubilden. Dadurch werden an der Oberfläche des Substrats mechanische Spannungen, die durch die Oxidation der Oberfläche des Grabens entstehen, abgebaut.

In all diesen Verfahren werden zusätzliche Prozeßschritte eingeführt, die die Prozeßkomplexität erhöhen. Das Auftreten der Unterätzungen am Grabenboden bei Gräben, die in die monokristalline Siliziumschicht eines SOI-Substrats geätzt sind, hängt mit der unter der monokristallinen Siliziumschicht angeordneten isolierenden Schicht aus SiO₂ und mit der Notwendigkeit, die monokristalline Siliziumschicht für die dielektrische Isolation vollständig zu durchätzen zusammen. Bei der Ätzung von Gräben in Substrate aus monokristallinem Silizium treten derartige Unterätzungen nicht auf. Die aus den drei Literaturstellen bekannten Maßnahmen sind zum Abbau von mechanischen Spannungen im Bereich der Unterätzungen bei einem Graben in einem SOI-Substrat nicht geeignet.

Ferner ist aus EP 0 296 754 A2 bekannt, zur Vermeidung von Spannungen beim Auffüllen von Gräben in SOI-Substraten zunächst durch thermische Oxidation an der Oberfläche der Siliziumschicht des SOI-Substrats eine dünne Oxidschicht zu bilden. Anschließend wird eine Schicht aus Polysilizium abgeschieden und oxidiert.

Aus WO-A-8504760 ist bekannt, zur Erzeugung von dotierten Gebieten in Seitenwänden von Gräben in Siliziumsubstraten eine Polysiliziumschicht abzuscheiden. Im oberen Bereich des Grabens und am Boden des Grabens wird die Polysiliziumschicht anschließend durch Implantation dotiert. Es wird ein Temperschritt durchgeführt, bei dem die Dotierstoffe innerhalb der Polysiliziumschicht diffundieren und sich gleichmäßig verteilen. Schließlich wird ein weiterer Temperschritt durchgeführt, bei dem Polysiliziumschicht oxidiert wird.

Aus US-PS 4 666 556 ist bekannt, zur Erzeugung einer ätzresistenten Siliziumdioxidschicht auf der Oberfläche eines Grabens, der in einem Siliziumsubstrat gebildet ist, eine konforme Schicht aus Polysilizium abzuscheiden und diese durch thermische Oxidation in Siliziumdioxid zu verwandeln.

Aus Journal of the Electrochemical Society, Bd. 139, Nr. 5, Juni 1992, Seiten 1690 bis 1692 ist ein Verfahren zur Abscheidung von SiO2 unter Verwendung von TEOS und O₃ in einem CVD-Verfahren bekannt.

Aus EP 0 423 722 A2 ist ein Verfahren zur Herstellung einer dielektrischen Isolationsstruktur in einem SOI-Substrat bekannt, bei dem in die Siliziumschicht des SOI-Substrats ein Graben geätzt wird, bei dem an den Kanten des Grabens Unterätzungen erzeugt werden, die nachfolgend durch eine thermische Oxidation verrundet werden. Die dielektrische Isolationsstruktur wird durch nachfolgende Abscheidung einer Polysiliziumschicht fertiggestellt.

Der Erfindung liegt das Problem zugrunde, ein Verfahren zur Herstellung eines Isolationsgrabens in einem SOI-Substrat anzugeben, bei dem durch mechanische Spannungen verursachte Kristalldefekte in der monokristallinen Siliziumschicht eines SOI-Substrats reduziert werden.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird nach der Grabenätzung eine Siliziumstruktur gebildet, die mindestens die Seitenwände des Grabens bedeckt und die die Unterätzungen ausfüllt. Die Siliziumstruktur besteht vorzugsweise aus amorphem Silizium. Die Siliziumstruktur wird in einem Temperschritt rekristallisiert. Die Rekristallisation geht dabei von der Seitenwand des Grabens, die durch die Oberfläche der monokristallinen Siliziumschicht des SOI-Substrats gebildet wird, aus. Anschließend wird die Oberfläche der Siliziumstruktur oxidiert. Bei dieser Oxidation wird die laterale Oxidation an der Grenzfläche zwischen der isolierenden Schicht und der monokristallinen Siliziumschicht des SOI-Substrats stark unterdrückt. Dadurch werden mechanische Spannungen, die zu Kristalldefekten in der monokristallinen Siliziumschicht führen können, wirksam reduziert.

Wird zur Grabenätzung eine Grabenmaske verwendet, die mindestens eine Si₃N₄-Schicht umfaßt und die während der Füllung des Grabens auf der Oberfläche der monokristallinen Siliziumschicht verbleibt, so kann durch thermische Oxidation gebildetes SiO₂ im oberen Bereich des Grabens leichter relaxieren, da es an der Oberfläche nicht durch die Si₃N₄-Schicht der Grabenmaske begrenzt ist. In diesem Fall werden daher auch an der Oberkante des Grabens mechanische Spannungen abgebaut.

Die Siliziumstruktur wird insbesondere durch ganzflächiges Abscheiden einer Siliziumschicht mit im wesentlichen konformer Kantenbedeckung und anschließendes anisotropes Ätzen der Siliziumschicht als Spacer gebildet. Die Siliziumschicht kann polykristallin oder amorph abgeschieden werden. Wegen der besseren Homogenität wird vorzugsweise amorphes Silizium verwendet.

Die Siliziumschicht kann dotiert oder undotiert abgeschieden werden. Wird die Siliziumschicht mit einer Dotierstoffkonzentration von mindestens 10²⁰ cm⁻³ erzeugt, so zeigt durch thermische Oxidation der Siliziumschicht gebildetes SiO₂ ein verbessertes Fließverhalten, das zu einem weiteren Abbau mechanischer Spannungen im Graben führt.

Zur Prozeßvereinfachung liegt es im Rahmen der Erfindung, den Temperschritt zur Rekristallisation der Siliziumstruktur mit der nachfolgenden Aufoxidation zusammenzufassen. Bei der Oxidation muß in diesem Fall sichergestellt werden, daß beim Einfahren auf die Oxidationstemperatur ein solches Temperaturprofil durchlaufen wird, daß die Rekristallisation einsetzt.

Es ist ebenfalls möglich, die Siliziumschicht als ganzes zu rekristallisieren und erst anschließend den anisotropen Ätzschritt zur Spacerbildung durchzuführen.

Im folgenden wird die Erfindung anhand der Ausführungsbeispiele und der Figuren näher erläutert.
- Figur 1: zeigt ein SOI-Substrat mit einer Grabenmaske und einem geätzten Graben, der am Boden Unterätzungen aufweist.
- Figur 2: zeigt das SOI-Substrat nach Abscheidung einer Siliziumschicht.
- Figur 3: zeigt das SOI-Substrat, nachdem aus der Siliziumschicht durch anisotropes Ätzen Spacer hergestellt worden sind.
- Figur 4: zeigt das SOI-Substrat nach Rekristallisation der Spacer.
- Figur 5: zeigt das SOI-Substrat nach teilweiser Aufoxidation der rekristallisierten Spacer.
- Figur 6: zeigt das SOI-Substrat nach vollständiger Aufoxidation der Siliziumspacer.
- Figur 7: zeigt das SOI-Substrat, nach Auffüllung verbliebenen Freiraums im Graben mit einer Siliziumfüllung und Aufoxidation der Oberfläche der Siliziumfüllung.

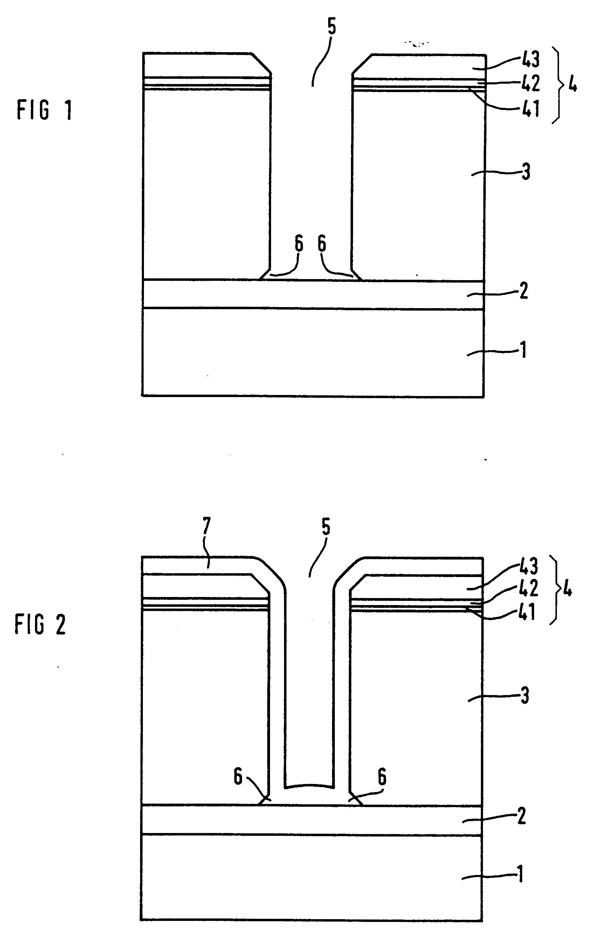

Ein SOI-Substrat umfaßt eine monokristalline Siliziumscheibe 1, die zum Beispiel p⁺-dotiert ist, eine darauf angeordnete isolierende Schicht 2 aus SiO₂ und eine darauf angeordnete monokristalline Siliziumschicht 3 (siehe Figur 1). Das SOI-Substrat ist vorzugsweise nach dem direkt wafer bonding (DWB)-Verfahren hergestellt. Die Dicke der isolierenden Schicht 2 beträgt zum Beispiel 2 µm. Die Dicke der monokristallinen Siliziumschicht 3 beträgt zum Beispiel 20 µm. Die monokristalline Siliziumschicht 3 ist zum Beispiel n-dotiert mit einer Dotierstoffkonzentration von 10¹⁴ Phosphoratome/cm³. In der monokristallinen Siliziumschicht 3 werden später Bauelemente hergestellt.

Auf die Oberfläche der monokristallinen Siliziumschicht 3 wird eine Grabenmaske 4 aufgebracht. Die Grabenmaske 4 umfaßt eine untere Schicht 41, eine mittlere Schicht 42 und eine obere Schicht 43. Die untere Schicht 41 wird zum Beispiel durch thermische Oxidation in einer Dicke von 50 nm hergestellt. Die mittlere Schicht 42 wird zum Beispiel durch CVD-Abscheidung von Si₃N₄ in einer Dicke von zum Beispiel 150 nm hergestellt. Die obere Schicht 43 wird zum Beispiel durch CVD-Abscheidung von SiO₂ in einer Dicke von 1600 nm hergestellt. Zur Strukturierung der Grabenmaske 4 wird auf diese Schichtenfolge eine Lackmaske (nicht dargestellt) aufgebracht. Die Grabenmaske 4 wird mit Hilfe der Lackmaske in einem CHF₃/O₂-Trockenätzprozeß strukturiert. Die Grabenmaske muß zum Ätzen eines tiefen Grabens geeignet sein.

Nach Entfernen der Lackmaske durch Lackstrippen wird mit Hilfe der Grabenmaske 4 ein Graben 5 in die monokristalline Siliziumschicht 3 geätzt (siehe Figur 1). Die Ätzung erfolgt zum Beispiel anisotrop in einem Trockenätzprozeß mit einer Cl₂/O₂-Chemie. Die Ätzung erfolgt selektiv zu SiO₂. Daher wird die Oberfläche der isolierenden Schicht 2 von der Ätzung nicht angegriffen. Sobald die Oberfläche der isolierenden Schicht 2 freigelegt ist, greift nur noch die laterale Komponente des Ätzprozesses die monokristalline Siliziumschicht 3 an. Dabei kommt es an der Grenzfläche zwischen der isolierenden Schicht 2 und der monokristallinen Siliziumschicht 3 zur Ausbildung von Unterätzungen 6. Diese bewirken, daß der Querschnitt des Grabens 5 an der Oberfläche der isolierenden Schicht 2 aufgeweitet wird (siehe Figur 1). Die Ausdehnung der Unterätzungen 6 hängt vom Ausmaß der Überätzung ab. Die Überätzung beträgt üblicherweise 10 bis 50 %.

Anschließend wird ganzflächig eine amorphe Siliziumschicht 7 mit im wesentlichen konformer Kantenbedeckung abgeschieden. Die Siliziumschicht 7 wird zum Beispiel in einem CVD-Verfahren bei 400 bis 500 °C abgeschieden (siehe Figur 2).

Die amorphe Siliziumschicht 7 kann undotiert oder dotiert abgeschieden werden, je nach Anforderungen an den Isolationsgraben von Seiten der Anwendung. Wird die amorphe Siliziumschicht 7 dotiert abgeschieden, so ist es vorteilhaft, die Dotierung auf mindestens 10²⁰ at/cm³ einzustellen. In diesem Fall zeigt SiO₂, das durch thermische Oxidation der Oberfläche entsteht, ein verstärktes Fließverhalten, analog zu dotierten Gläsern wie Phosphorsilikatglas oder Borsilikatglas, nur schwächer ausgeprägt. Durch dieses Fließverhalten werden mechanische Spannungen zusätzlich reduziert.

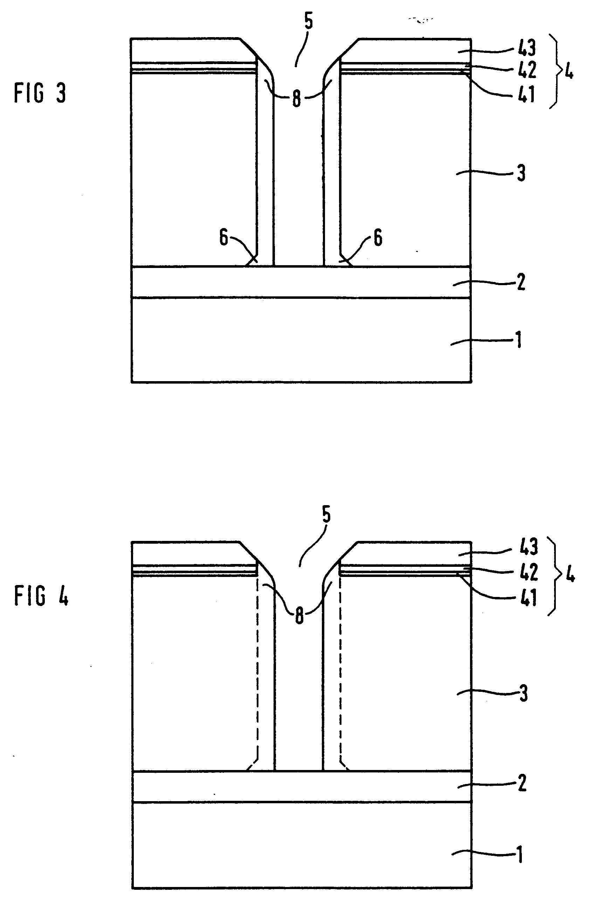

Die Schichtdicke der amorphen Siliziumschicht 7 wird von der Ausdehnung der Unterätzung 6 abhängig eingestellt. Sie beträgt zum Beispiel 500 nm. In einem anisotropen Trockenätzprozeß, zum Beispiel in einem HBr/Cl₂-Plasma, wird die amorphe Siliziumschicht 7 geätzt, bis waagerechte Oberflächen der Grabenmaske 4 und der isolierenden Schicht 2 freigelegt sind (siehe Figur 3). Dabei entstehen an den Seitenwänden des Grabens 5 Spacer 8.

In einem Temperschritt bei zum Beispiel 800 °C rekristallisiert das amorphe Silizium des Spacers 8 ausgehend von der Grenzfläche zur monokristallinen Siliziumschicht 3. Der Temperschritt wird solange durchgeführt, bis der gesamte Spacer 8 rekristallisiert ist. In Figur 4 ist die Grenzfläche zwischen der monokristallinen Siliziumschicht 3 und dem rekristallisierten Spacer 8 gestrichelt eingezeichnet. Nach der Rekristallisation fügt sich das Kristallgitter im Spacer 8 in die Ordnung in der monokristallinen Siliziumschicht 3 ein.

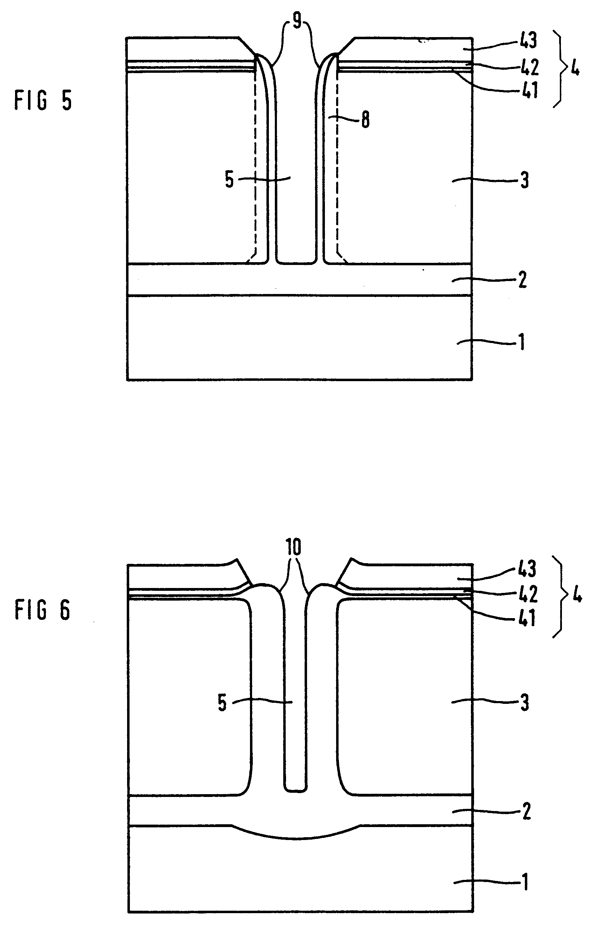

Anschließend werden die Spacer zum Beispiel teilweise aufoxidiert (siehe Figur 5). Dabei entsteht an der Oberfläche der Spacer 8 eine SiO₂-Schicht 9. Die Aufoxidation erfolgt zum Beispiel in feuchter Atmosphäre bei 1000 bis 1200 °C. Die Temperschritte zur Rekristallisation und zur Aufoxidation können durch ein geeignetes Temperaturprofil zusammengefaßt werden. Die SiO₂-Schicht 9 weist eine Dicke senkrecht zur Oberfläche der Spacer 8 von etwa 400 nm auf. Am oberen Rand des Grabens 5 und am Boden des Grabens 5 zeigt die SiO₂-Schicht 9 eine leichte Abrundung, die kaum als Vogelschnabel bezeichnet werden kann. In der SiO₂-Schicht 9 treten mechanische Spannungen im wesentlichen an der Grenzfläche zum Spacer 8 auf. In der monokristallinen Siliziumschicht 3 bilden sich in diesem Fall keine Defekte aus.

Zur Fertigstellung des Isolationsgrabens liegt es im Rahmen der Erfindung, den im Graben 5 verbliebenen Freiraum (siehe Figur 5) durch ganzflächige Abscheidung einer SiO₂-Schicht mit konformer Kantenbedeckung aufzufüllen. Dazu ist eine CVD-Abscheidung unter Verwendung eines O₃ und Si(OC₂H₅)₄ enthaltenden Prozeßgases, sogenanntes Ozon-Teos, geeignet.

In einer anderen Ausführungsform der Erfindung werden ausgehend von Figur 4 die Spacer 8 vollständig aufoxidiert. Dabei entstehen SiO₂-Spacer 10 (siehe Figur 6). Die thermische Oxidation erfolgt zum Beispiel in feuchter Atmosphäre bei 1000 bis 1200 °C. Zur Prozeßvereinfachung können die Temperschritte zur Rekristallisation und zur Aufoxidation bei Verwendung eines angepaßten Temperaturprofils zusammengefaßt werden. Bei der vollständigen Aufoxidation der Spacer 8 kommt es am Boden des Grabens und an der Oberkante des Grabens zur Ausbildung von Vogelschnabelstrukturen. Die dadurch verursachten mechanischen Spannungen sind jedoch deutlich geringer als bei einer vergleichbaren Aufoxidation eines unbehandelnden Grabens Damit im Zusammenhang steht eine deutlich reduzierte Kristalldefektdichte in der monokristallinen Siliziumschicht 3.

Sollen in der monokristallinen Siliziumschicht 3 dem Graben benachbarte, dotierte Gebiete erzeugt werden, so kann dies durch Ausdiffusion aus dem Spacer 8 erfolgen, falls dieser aus dotiertem Silizium gebildet ist. Ist die Dotierstoffkonzentration im Spacer 8 mindestens 10²⁰ cm⁻³, so zeigt nach der vollständigen Aufoxidation des Spacers 8 der SiO₂-Spacer 10 ein verbessertes Fließverhalten analog zu dotierten Gläsern wie Phosphorsilikatglas oder Borsilikatglas. Dadurch werden zusätzlich mechanische Spannungen reduziert.

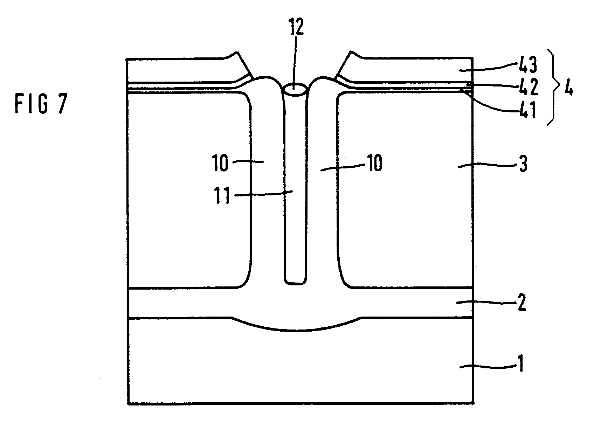

Zwischen den SiO₂-Spacern 10 verbliebener Freiraum im Graben 5 kann im folgenden durch Abscheidung einer amorphen Siliziumsschicht und anschließender Ätzung mit einer Siliziumfullung 11 aufgefüllt werden (siehe Figur 7). Anschließend wird die Oberfläche der Siliziumfüllung 11 zum Beispiel durch thermische Oxidation in feuchter Atmosphäre bei 1000 bis 1200 °C mit einem Isolationsabschluß 12 aus SiO₂ versehen, der die Silizumfüllung 11 vollständig abdeckt.

Nach Fertigstellung des Isolationsgrabens wie anhand von Figur 5 oder Figur 7 geschildert, werden im Rahmen eines Planarprozesses Bauelemente in der monokristallinen Siliziumschicht 3 hergestellt. Diese Bauelemente werden zur Isolation gegeneinander in Inseln der monokristallinen Siliziumschicht 3 angeordnet, die jeweils vollständig von einem Isolationsgraben umgeben sind.

Nach dem erfindungsgemäßen Verfahren hergestellte Isolationsgräben sind insbesondere geeignet zur Integration in einen 500 Volt Smart-Power-Prozeß.

Durch die Kombination von Defektreduzierung mit Seitenwanddotieren und Grabenauffüllen erlaubt das Verfahren eine stark vereinfachte Prozeßführung. Da in dem erfindungsgemäßen Verfahren nur konventionelle Verfahren aus der CMOS-Fertigung Anwendung finden, ist es kombatibel mit jedem CMOS-Verfahren. Zur Optimierung und Anpassung des erfindungsgemäßen Verfahrens an unterschiedliche Grabengeometrien ist lediglich eine Variation der Dicke der abgeschiedenen Siliziumschicht und der Oxidationszeit erforderlich.

## Patentansprüche

1. Verfahren zur Herstellung eines Isolationsgrabens in einem SOI-Substrat,
- bei dem das SOI-Substrat eine monokristalline Siliziumscheibe (1), eine darauf angeordnete isolierende Schicht (2) aus SiO₂ und eine darauf angeordnete monokristalline Siliziumschicht (3) umfaßt,
- bei dem in die monokristalline Siliziumschicht (3) ein Graben (5) geätzt wird, der bis auf die isolierende Schicht (2) reicht und dessen Querschnitt an der Oberfläche der isolierenden Schicht (2) durch Unterätzungen (6) der monokristallinen Siliziumschicht (3) aufgeweitet ist,
- bei dem der im Graben verbliebene Freiraum mit einer SiO₂ oder Silizium enthaltenden Isolationsstruktur (11, 12) aufgefüllt wird,
**dadurch gekennzeichnet,** daß
- nach der Grabenätzung eine Siliziumstruktur (7) aus amorphem Silizium auf dem Graben gebildet wird, die mindestens die Seitenwände des Grabens (5) bedeckt und die die Unterätzungen (6) ausfüllt,
- die Siliziumstruktur (7) in einem Temperschritt ausgehend von der Grenzfläche zur monokristallinen Siliziumschicht (3) rekristallisiert wird, so daß sich das Kristallgitter in der rekristallisierten Siliziumstruktur (8) in die Ordnung in der monokristallinen Siliziumschicht (3) einfügt,
- die rekristallisierte Siliziumstruktur (8) mindestens teilweise aufoxidiert wird.

2. Verfahren nach Anspruch 1,
bei dem die Siliziumstruktur (7) durch ganzflächiges Abscheiden einer amorphen Siliziumschicht mit im wesentlichen konformer Kantenbedeckung und anschließendes anisotropes Ätzen als Spacer (8) gebildet wird.

3. Verfahren nach Anspruch 1 oder 2,
bei dem die Siliziumstruktur (7) aus dotiertem Silizium mit einer Dotierstoffkonzentration von mindestens 10¹⁸ at/cm³ gebildet wird.

4. Verfahren nach einem der Ansprüche 1 bis 3,
bei dem Rekristallisation und Aufoxidation der Siliziumstruktur (8) in einem Temperschritt erfolgen.

5. Verfahren nach einem der Ansprüche 1 bis 4,
- bei dem zur Fertigstellung der Isolationsstruktur im Graben (5) verbliebener Freiraum mit einer Siliziumfüllung (11) aufgefüllt wird und
- bei dem durch Aufoxidation der Oberfläche der Siliziumfüllung (11) ein Isolationsabschluß (12) gebildet wird, der die Silizumfüllung (11) vollständig überdeckt.

6. Verfahren nach einem der Ansprüche 1 bis 4,
bei dem zur Fertigstellung der Isolationsstruktur im Graben (5) verbliebener Freiraum mit SiO₂, das in einem CVD-Verfahren konform abgeschieden wird, aufgefüllt wird.

7. Verfahren nach Anspruch 6,
bei dem die Füllung des Grabens (5) in einem CVD-Verfahren unter Verwendung eines O₃ und Si(OC₂H₅)₄ enthaltenden Prozeßgases erfolgt.

8. Verfahren nach einem der Ansprüche 1 bis 7,
bei dem die Ätzung des Grabens (5) unter Verwendung einer Grabenmaske (4) erfolgt, die eine Schichtenfolge aus einer unteren Schicht (41) aus SiO₂, einer mittleren Schicht (42) aus Si₃N₄ und einer oberen Schicht (43) aus SiO₂ umfaßt.

## Claims

1. Process for fabricating an insulation trench in an SOI substrate,
- in which the SOI substrate comprises a monocrystalline silicon wafer (1), an insulating layer (2) made of SiO₂ arranged on top of the said silicon wafer, and a monocrystalline silicon layer (3) arranged on top of the said insulating layer,
- in which a trench (5) is etched into the monocrystalline silicon layer (3), which trench reaches down to the insulating layer (2) and the cross section of which trench is widened at the surface of the insulating layer (2) by means of undercuts (6) of the monocrystalline silicon layer (3),
- in which the free space that has remained in the trench is filled with an insulation structure (11, 12) containing SiO₂ or silicon,
characterized in that
- after the etching of the trench, a silicon structure (7) made of amorphous silicon is formed on the trench, which structure covers at least the side walls of the trench (5) and fills in the undercuts (6),
- the silicon structure (7) is recrystallized in a heat-treatment step proceeding from the interface with the monocrystalline silicon layer (3), with the result that the crystal lattice in the recrystallized silicon structure (8) adapts to the order in the monocrystalline silicon layer (3),
- the recrystallized silicon structure (8) is at least partly oxidized.

2. Process according to Claim 1,
in which the silicon structure (7) is formed by the whole-area deposition of an amorphous silicon layer with essentially conformal edge coverage and subsequent anisotropic etching as spacer (8).

3. Process according to Claim 1 or 2,
in which the silicon structure (7) is formed from doped silicon with a dopant concentration of at least 10¹⁸ at/cm³.

4. Process according to one of Claims 1 to 3,
in which the recrystallization and oxidation of the silicon structure (8) take place in a heat-treatment step.

5. Process according to one of Claims 1 to 4,
- in which, in order to complete the insulation structure, free space that has remained in the trench (5) is filled with a silicon filling (11), and
- in which an insulation termination (12) is formed by oxidizing the surface of the silicon filling (11), and completely covers the silicon filling (11).

6. Process according to one of Claims 1 to 4,
in which, in order to complete the insulation structure, free space that has remained in the trench (5) is filled with SiO₂ which is conformally deposited in a CVD process.

7. Process according to Claim 6,
in which the trench (5) is filled in a CVD process using a process gas containing O₃ and Si(OC₂H₅)₄.

8. Process according to one of Claims 1 to 7,
in which the trench (5) is etched using a trench mask (4) comprising a layer sequence formed by a bottom layer (41) made of SiO₂, a middle layer (42) made of Si₃N₄ and a top layer (43) made of SiO₂.

## Revendications

1. Procédé de fabrication d'une rainure d'isolation dans un substrat de type SOI,
- dans lequel le substrat de type SOI comprend un disque (1) de silicium monocristallin sur lequel est disposée une couche isolante (2) en SIO₂ sur laquelle est disposée une couche de silicium monocristallin (3),
- dans lequel, dans la couche de silicium monocristallin (3), on grave une rainure (5) qui s'étend jusqu'à la couche isolante (2) et dont la section transversale à la surface de la couche isolante (2) est élargie par des gravures en contre-dépouille (6) de la couche de silicium monocristallin (3),
- dans lequel l'espace libre restant dans la rainure est rempli d'une structure d'isolation (11, 12) contenant du SiO₂ ou du silicium, caractérisé en ce que
- après la gravure des rainures, une structure de silicium (7) en silicium amorphe est formée sur la rainure, qui recouvre au moins les parois latérales de la rainure (5) et remplit les gravures en contre-dépouille (6),
- la structure de silicium (7) est recristallisée dans une étape de recuit, à partir de la surface frontière vers la couche de silicium monocristallin (3), de sorte que le réseau cristallin dans la structure de silicium (8) recristallisée s'intègre dans l'ordre de la couche de silicium monocristallin (3),
- la structure de silicium recristallisé (8) est au moins partiellement oxydée.

2. Procédé selon la revendication 1,
dans lequel la structure de silicium (7) est formée par dépôt sur toute la surface d'une couche de silicium amorphe en épousant essentiellement la forme des bords, et ensuite est formée en tant qu'écarteur (8) par gravure anisotrope.

3. Procédé selon la revendication 1 ou 2,
dans lequel la structure de silicium (7) est formée de silicium dopé présentant une concentration en matériau dopant d'au moins 10¹⁸ atomes/cm³.

4. Procédé selon l'une des revendications 1 à 3,
dans lequel la recristallisation et l'oxydation de la structure de silicium (8) s'effectuent dans une étape de recuit.

5. Procédé selon l'une des revendications 1 à 4,
- dans lequel, pour la réalisation de la structure d'isolation un espace libre restant dans la rainure (5) est rempli d'un remplissage de silicium (11), et
- dans lequel, par oxydation de la surface du remplissage de silicium (11), on forme une fermeture d'isolation (12) qui recouvre complètement le remplissage de silicium (11).

6. Procédé selon l'une des revendications 1 à 4,
dans lequel, pour réaliser la structure d'isolation un espace libre restant dans la rainure (5) est rempli de SiO₂ qui est déposé en épousant sa forme par un procédé CVD.

7. Procédé selon la revendication 6,
dans lequel le remplissage de la rainure (5) s'effectue par un procédé CVD en recourant à un gaz de traitement contenant O₃ et Si(OC₂H₅)₄.

8. Procédé selon l'une des revendications 1 à 7,
dans lequel la gravure de la rainure (5) s'effectue en utilisant un masque de rainure (4) qui présente une succession de couches constituées d'une couche inférieure (41) en SiO₂, d'une couche centrale (42) en Si₃N₄ et d'une couche supérieure (43) en SiO₂.
